Europäisches Patentamt

European Patent Office

Office européen des brevets

(11) Publication number: **0 461 795 A2**

# EUROPEAN PATENT APPLICATION

(21) Application number: **91305012.6**

(22) Date of filing: **03.06.91**

(51) Int. Cl.⁵: **H01L 33/00, H01S 3/085**

(30) Priority: **13.06.90 US 537856**

(43) Date of publication of application:
**18.12.91 Bulletin 91/51**

(84) Designated Contracting States:
**DE FR GB**

(71) Applicant: **AMERICAN TELEPHONE AND TELEGRAPH COMPANY**
**550 Madison Avenue**
**New York, NY 10022(US)**

(72) Inventor: **Chu, Sung-Nee George**
**55 Murray Hill Blvd.**
**Murray Hill, New Jersey 07974(US)**
Inventor: **Logan, Ralph Andre**
**179 Mills Street**
**Morristown, New Jersey 07960(US)**
Inventor: **Tanbun-Ek, Tawee**
**708B Springfield Avenue**
**Summit, New Jersey 07901(US)**

(74) Representative: **Watts, Christopher Malcolm Kelway et al**
**AT&T (UK) LTD. AT&T Intellectual Property**
**Division 5 Mornington Road**
**Woodford Green Essex IG8 OTU(GB)**

(54) **Method of making a DFB laser.**

(57) Disclosed is a method of making In-based DFB lasers that can reliably prevent erosion of the grating (12) in the InP substrate (11) surface during heating of the substrate to the deposition temperature for the overlying epitaxial quaternary material (e.g., 130), and that can make possible deposition of essentially defect-free overlying quaternary material. The method comprises heating of the substrate in an appropriate As and P-containing atmosphere and, optionally, deposition of a minor amount of As, Ga and P-containing protective material (121) at an intermediate temperature, e.g., at 500°C. Exemplarily the atmosphere consists essentially of $H_2$, $AsH_3$ and $PH_3$, at 500°C a very small amount (corresponding to only a few monolayers) of GaAsP is deposited, followed by deposition of a somewhat larger amount (corresponding to about 7 nm) of InGaAsP ($\lambda_g \sim 1$ μm). Upon completion of the deposition of the protective material the substrate is heated in $H_2$-$AsH_3$-$PH_3$ to 625°C and epitaxial overlayer material deposited in conventional fashion.

## Field of the Invention

This invention pertains to methods of making a semiconductor laser.

## Background of the Invention

An important substrate material for semiconductor lasers is InP, since it can be used to grow lasers that emit radiation of wavelength at or near 1.5 $\mu$m. This wavelength regime is known to be particularly advantageous for optical fiber communication systems, due to the low loss of $SiO_2$-based optical fiber in that regime. However, attempts to grow InP-based distributed feedback (DFB) lasers by MOVPE or other vapor deposition technique have not been fully satisfactory, due to erosion of the grating during heating of the grating-bearing InP substrate to the deposition temperature. See, for instance, J. S. Evans et al., Proceedings of the 2nd NATO Workshop on "Materials Aspects of InP", U. of Lancaster, England, March 1983, Vol. 2, pp. 45.1-45.8. This erosion is believed to be associated with the high vapor pressure of P. The erosion is less severe if the grating is formed in quaternary material (e.g., InGaAsP). However, this requires an additional processing step (namely, placing of the quaternary layer onto the InP substrate prior to grating formation). This clearly is not desirable.

Furthermore, laser performance can be negatively affected by the presence of defects in the optically active region of the laser and in regions adjacent thereto. Thus it is important that the grating-overgrowth interface of a DFB laser be essentially defect free. Prior art techniques generally have not been reproducibly able to, at the same time, substantially preserve the integrity of the grating in the surface of a InP substrate of a InP-based DFB laser and to ensure an essentially defect-free grating/overgrowth interface. In view of the importance of InP-based DFB lasers it would be highly desirable to have available a method of producing such lasers that can be free of the above discussed shortcomings of the prior art. This application discloses such a method.

## Summary of the Invention

In a broad aspect the invention is a method of making an article that comprises a DFB laser. The method comprises providing a P-containing semiconductor body, exemplarily an InP wafer. It further comprises processing the body such that on at least a portion of the surface of the body are formed grating means, typically an essentially regular sequence of elevated and depressed elongate features. It still further comprises heating the body to a deposition temperature and depositing on at least a part of the grating means epitaxial semiconductor material of composition different from that of the body. The heating is carried out such that during at least part of the time the grating means are in contact with a As and P-containing atmosphere, with the composition and pressure of said atmosphere chosen such as to substantially reduce erosion of the grating means during the heating. In a preferred embodiment the atmosphere contains both $AsH_3$ and $PH_3$, with the ratio chosen such that the residual grating depth is at least 10%. The method further comprises one or more further steps, generally of a conventional nature, towards completion of the article.

Currently preferred embodiments also comprise growth, at an intermediate temperature, of a relatively minor amount of protective material of composition different from that of the semiconductor body on the grating means. Exemplarily the protective material comprises InGaAsP, grown at about 500 °C. A particularly preferred embodiment comprises depositing at the intermediate temperature a very small amount (corresponding to only a few monolayers) of Ga, As and P-containing material, followed by deposition of a somewhat larger amount (corresponding to a few nm) of the In, Ga, As and P-containing material. This is followed by heating to the deposition temperature and deposition of the previously referred to epitaxial semiconductor material.

## Brief Description of the Drawings

FIG. 1 schematically depicts an exemplary multilayer semiconductor structure according to the invention;

FIG. 2 exemplifies the relationship between composition of the atmosphere and residual grating depth; and

FIG. 3 is an electron-micrograph of a multilayer semiconductor structure produced according to the invention.

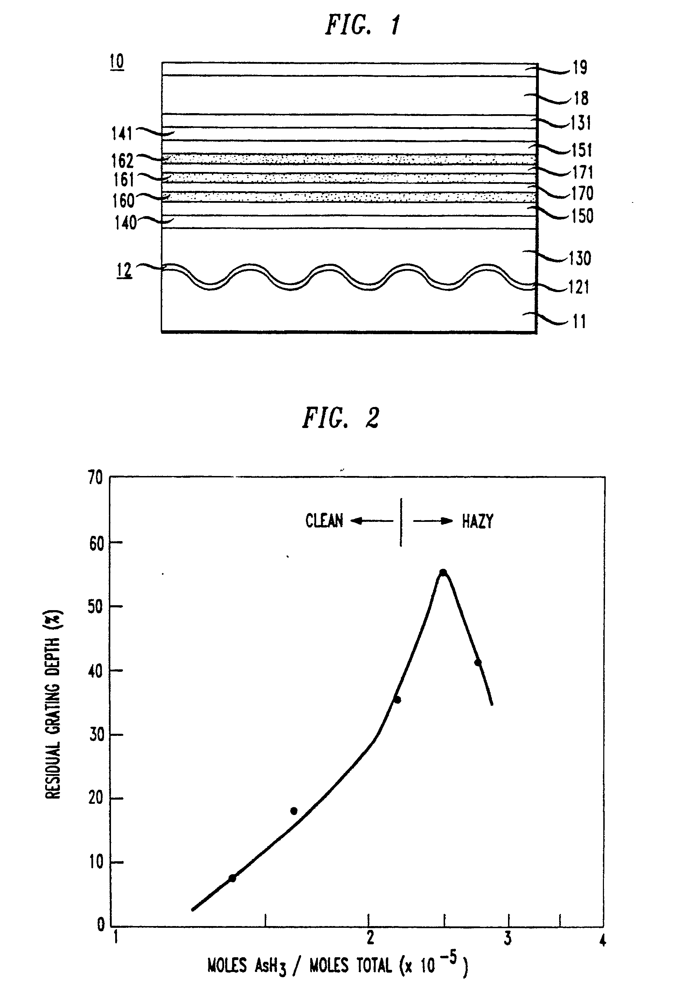

In FIG. 1 no attempt has been made to show exact dimensions and/or proportions.

## Detailed Description of a Preferred Embodiment

FIG. 1 schematically depicts an exemplary structure 10 suitable for making a DFB laser. Substrate 11 exemplarily is a (100) n-type single crystal InP body, typically a thin InP wafer. On a major surface of the wafer is formed a regularly spaced sequence of elongate recessed features, which result in grating 12. Exemplarily the features are parallel to the (01$\overline{1}$) direction and have a repeat distance of about 240 nm. The substrate surface can be patterned by a known method that exemplarily comprises holographic photolithography and chemical etching. The recessed features typically have a depth in the range 20-200 nm prior to any heat treatment.

FIG. 1 further shows protective material 121 and a multiplicity of single crystal semiconductor layers grown on the patterned surface of the substrate. Layer 130 is InGaAsP of composition having an energy gap corresponding to a wavelength ($\lambda_g$) of 1.08 $\mu$m, layers 140 and 150 have $\lambda_g$ of 1.16 and 1.25 $\mu$m, respectively, quantum wells 160, 161 and 162 are InGaAs of $\lambda_g$ = 1.67 $\mu$m, and barrier layers 170 and 171 are InGaAsP of $\lambda_g$ = 1.25 $\mu$m. Layers 151, 141 and 131 are of essentially the same composition as layers 150, 140 and 130, respectively. Layer 18 is p-InP, and layer 19 is p$^+$ InGaAsP. The art conventionally specifies composition in terms of $\lambda_g$, as is done herein. Furthermore, expressions such as "InGaAsP" are well understood to merely list the chemical constituents and not to imply the presence of equimolar amounts of the constituents.

It will be appreciated that the structure of FIG. 1 is exemplary only, and that the invention is not limited to this particular structure. For instance, lasers according to the invention need not be quantum well lasers, or could have fewer or more than three quantum wells. Furthermore, the presence of protective layer 121 is optional, although currently preferred. Still furthermore, the protective layer may undergo changes during a later processing step such that in the finished structure the layer may not be continuous and uniform as shown in the figure.

Exemplarily, layer 130 is about 130 nm thick, layers 140, 150, 151 and 141 each are about 25 nm thick, barrier layers 170 and 171 each are about 22.5 nm thick, and the quantum well layers 160, 161 and 162 have a thickness in the range 5-9 nm.

From a structure as shown in FIG. 1 lasers can be made by conventional methods that typically include photolithography, etching, re-growth, cleaving, deposition of contacts, and possibly deposition of reflecting and/or antireflection coatings.

The structure of FIG. 1 exemplarily can be grown as follows: after the grating is produced by a conventional technique the InP wafer is heated to an intermediate temperature (typically in the range 450-550° C, exemplarily about 500° C) under a As and P-containing atmosphere. In preferred exemplary embodiments the atmosphere comprises, in addition to H$_2$, PH$_3$ and AsH$_3$. Upon attainment of the appropriate intermediate temperature a minor amount (e.g., corresponding to a 5-15 nm, exemplarily 7 nm thick layer) of protective InGaAsP ($\lambda_g$ about 1 $\mu$m) is deposited on the grating, to further protect the grating against thermal erosion. Optionally a very small amount of Ga, As and P-containing material [corresponding to only a few (exemplarily fewer than 10) monolayers] is deposited prior to deposition of the protective InGaAsP. Subsequently the wafer is heated under the As and P-containing atmosphere to the growth temperature (typically in the range 575-650° C, exemplarily about 625° C), followed by growth of the sequence of InGaAsP layers 130-150 of FIG. 1. This in turn is followed by growth of the quantum well structure, which is followed by growth of the InGaAsP layers 151-131, of the (exemplarily 2 $\mu$m thick) p-InP cladding layer 18, and of the (exemplarily 120 nm thick) p$^+$-InGaAsP (5x10$^{18}$cm$^{-3}$Zn) contact layer 19.

Exemplarily the epitaxial layers are grown in a horizontal reactor with automatic vent-run pressure balancing means to minimize any transient pressure which might occur during the gas switching sequences. Purified H$_2$ can be used as carrier gas, with 5% AsH$_3$, 20% PH$_3$, trimethyl indium (from a source held at 30° C) and trimethyl gallium (from a source held at -15° C) as semiconductor precursors. Exemplary dopant sources are 200 ppm H$_2$S in H$_2$ and diethyl zinc for n- and p-type doping, respectively. Typical growth rates are 1.5 nm/sec for InGaAs and 1 nm/sec for InP.

Heating of the wafer with the grating thereon under a As and P-containing atmosphere is a significant aspect of the invention and reduces thermal erosion of the grating. For instance, if gratings of the type described above are heated from room temperature to 625° C in 3 minutes in a pure H$_2$ atmosphere then in most cases most of the grating vanishes, likely due to mass transport of InP on the corrugated substrate surface. Similar erosion occurs if heating takes place in H$_2$ and PH$_3$. On the other hand, processing according to the invention (which comprises heating of the substrate with the grating thereon in an appropriate As and P-containing atmosphere) can substantially reduce thermal erosion of the grating. By a "substantial reduction" we mean that after completion of the epitaxial overgrowth the residual grating depth in essentially all parts of the grating is at least 10%, preferably 20% or more, of the original depth of the recessed lines in the semiconductor surface.

A currently preferred As and P-containing atmosphere is a mixture of AsH$_3$ and PH$_3$ with H$_2$ carrier gas. We have found that the residual grating depth typically depends on the AsH$_3$/PH$_3$ ratio in the atmosphere. This is exemplified by FIG. 2, which was obtained keeping the flow of PH$_3$ and H$_2$ constant (PH$_3$/H$_2$ mole ratio 2.2x10$^{-3}$). As can he seen from the figure, the residual grating depth strongly increases with increasing AsH$_3$ content, reaching a maximum of over 50% at about

2.5x10$^{-5}$ moles of AsH$_3$ per mole total. The data of FIG. 2 was obtained by heating a given sample from room temperature to 625°C in 3 minutes and holding it at that temperature for 5 minutes before cooling.

Under the conditions of the experiment, it was observed that, for AsH$_3$ contents above about 2x10$^{-5}$, hazy-looking surfaces resulted. This frequently will be undesirable, and we currently prefer conditions (exemplarily AsH$_3$ content $\leq$ 2x10$^{-5}$) that can result in shiny, clean-looking surfaces. It will be understood that the optimal AsH$_3$/PH$_3$ ratio (or, more generally, the optimal concentration of As and P in the atmosphere) may depend on the details of the growth procedure and can not be specified generally. However, a minor amount of simple experimentation will usually suffice to determine a concentration that yields satisfactory results.

Currently preferred embodiments comprise deposition, at an intermediate temperature below the temperature for growth of the epitaxial overlayer, of a minor amount of protective material of composition different from that of the substrate (exemplarily comprising InGaAsP, $\lambda_g$~1 $\mu$m, and optionally comprising a very small amount of GaAsP). An exemplary preferred embodiment comprises heating of the InP substrate with a 100 nm deep grating thereon under H$_2$-AsH$_3$-PH$_3$ (about 2x10$^{-5}$ AsH$_3$, 2.2x10$^{-3}$PH$_3$) to 500°C. Upon attainment of this intermediate temperature the atmosphere is changed by addition of Ga from trimethyl gallium. After 1 second the atmosphere is again appropriately changed such that ~10 nm of InGaAsP ($\lambda$g~1 $\mu$m) are grown at 500°C. Subsequently the atmosphere is again changed to H$_2$-AsH$_3$-PH$_3$ and the wafer is heated in this atmosphere to 625°C. Upon attainment of the growth temperature, the epitaxial overgrowth of the desired quaternary waveguide layer and subsequent layers is carried out in conventional fashion. Whereas the above-described two-stage deposition of protective material is not an essential process step, preferred embodiments of the invention do comprise deposition of protective material, preferably the two-stage deposition, since such processing can reliably avoid excessive erosion of the grating.

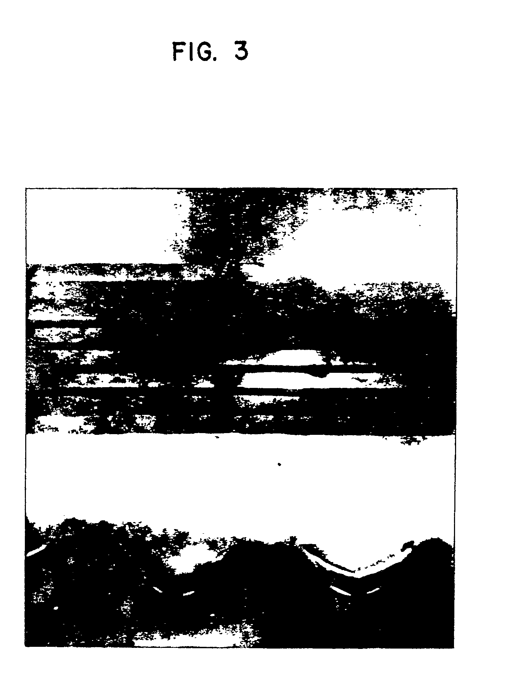

As exemplified by FIG. 3, the deposited quaternary protective material frequently does not remain as a continuous and uniform layer on the grating, but may accumulate in the valleys of the grating during high temperature processing. Since the quaternary protective material typically has a dielectric constant larger than that of the InP substrate and of the adjacent quaternary layer, this may result in increased effective grating depth and thus be an advantageous feature of the preferred inventive method.

A further significant aspect of the inventive method is its ability to produce essentially defect-free epitaxial growth on a InP substrate with a grating thereon. Thus, the method is able to produce InP-based DFB lasers having grating depths of at least 10 nm, with essentially defect-free (i.e., essentially free of dislocations, stacking faults and interfacial particles) semiconductor material overlying the grating. FIG. 3, a cross section transmission electron micrograph of a InP-based structure as shown in FIG. 1, produced as described above, clearly reveals the essentially defect-free nature of the epitaxial overgrowth.

## Claims

1. A method of making an article comprising a semiconductor laser, the method comprising
   a) providing a semiconductor body of a first composition having a major surface;
   b) processing the body such that on at least a portion of the surface an essentially regular sequence of elevated and depressed elongate features is formed, said sequence of features to be referred to as a grating means;
   c) heating the body to a deposition temperature and depositing on the major surface epitaxial semiconductor material of a second composition different from the first composition; and
   d) carrying out one or more further steps towards completion of the article;
   CHARACTERIZED IN THAT
   e) the semiconductor body comprises InP; and in that step c) comprises
   f) heating the body such that during at least a part of the time of heating the grating means are in contact with a As and P-containing atmosphere, the composition and pressure of said atmosphere chosen such as to substantially reduce erosion of the grating means during heating to the deposition temperature.

2. Method of claim 1, wherein step c) comprises heating the body to an intermediate temperature in the range 450-550°C, and depositing at the intermediate temperature onto at least a part of the grating means a quantity of protective material comprising Ga, As and P.

3. Method of claim 2, wherein the quantity of protective material comprises a first quantity of material consisting substantially of Ga, As and P, and a second quantity of material consisting substantially of In, Ga, As and P.

4. Method of claim 2, wherein the body is in contact with an As and P-containing atmosphere at least during the time the body is at the intermediate temperature and the time of heating the body from the intermediate temperature to the deposition temperature.

5. Method of claim 1, wherein the process is carried out such that subsequent to overgrowth of the grating means with the epitaxial semiconductor material at the deposition temperature, the residual depth of the grating means is at least 10%.

6. Method of claim 5, wherein the residual depth is at least 20%.

7. Method of claim 5, wherein the process is carried out such that the grating depth is at least 10 nm.

8. Method of claim 1, wherein step d) comprises producing a multiplicity of semiconductor lasers from the body.

9. Method of claim 1, wherein step c) comprises
i) heating the body to an intermediate temperature in the range 450-550°C, with the body being in contact with a $H_2$, P, and As-containing atmosphere during at least part of the heating;
ii) depositing at the intermediate temperature a first quantity of Ga, As and P-containing material on at least part of the grating means;
iii) depositing at the intermediate temperature a second quantity of In, Ga, As and P-containing material on at least the part of the grating means with the first quantity of material thereon; and
iv) heating the body to the growth temperature, with the body being in contact with a $H_2$, P and As-containing atmosphere, the proportions of $H_2$ to P and P to As in the atmosphere chosen such that during heating to the growth temperature the major surface does not become hazy-looking.

FIG. 3